Europäisches Patentamt

European Patent Office

Office européen des brevets

(11) Publication number: **0 503 082 A1**

# EUROPEAN PATENT APPLICATION
## published in accordance with Art. 158(3) EPC

(21) Application number: **91916789.0**

(22) Date of filing: **01.10.91**

(86) International application number:
**PCT/JP91/01318**

(87) International publication number:
**WO 92/05867 (16.04.92 92/09)**

(51) Int. Cl.⁵: **B01J 19/08**, C23C 16/50,
C30B 29/04, B01J 19/12,
C01B 31/06, H01L 21/205,
H01L 21/302, H01L 21/31,
H05H 1/30, H05H 1/46

(30) Priority: **01.10.90 JP 263447/90**

(43) Date of publication of application:
**16.09.92 Bulletin 92/38**

(84) Designated Contracting States:
**BE CH DE FR GB IT LI NL SE**

(71) Applicant: **IDEMITSU PETROCHEMICAL COMPANY LIMITED**
**1-1, Marunouchi 3-chome Chiyoda-ku**
**Tokyo 100(JP)**

(72) Inventor: **ITATANI, Ryohei**
**11-18, Ohtaka-cho, Daigo, Fushimi-ku**
**Kyoto-shi, Kyoto 601-13(JP)**
Inventor: **ISOZAKI, Toshio Idemitsu**
**Petrochemical Company Ltd**
**1660, Kamiizumi, Sodegaura-shi**
**Chiba-ken 299-02(JP)**
Inventor: **HAYASHI, Nariyuki Idemitsu**
**Petrochemical Comp. Ltd**
**1-1, Marunouchi 3-chome**
**Chiyoda-ku, Tokyo 100(JP)**

(74) Representative: **TER MEER - MÜLLER - STEINMEISTER & PARTNER**
**Mauerkircherstrasse 45**
**W-8000 München 80(DE)**

(54) **DEVICE FOR GENERATING MICROWAVE PLASMA AND METHOD OF MAKING DIAMOND FILM UTILIZING SAID DEVICE.**

(57) A device for generating mirowave plasma which emits microwaves to an electric discharge space in order to stably generate plasma covering a wide range at a fixed position for a long time, characterized by being provided with a plurality of microwave emitting means to continuously emit microwave pulses at different timings in emitting microwave pulses; and a method of making diamond film characterized by synthesizing diamond thin film utilizing said microwave plasma generating device for efficiently forming diamond thin film uniform in thickness on a wide-area substrate; thereby capable of providing a useful microwave generating device and diamond thin film.

Fig. 1

## TECHNICAL FIELD

The present invention relates to a microwave plasma generating apparatus and a process for preparing a diamond layer by utilizing same and, more particularly, to a microwave plasma generating apparatus capable of generating plasma of a large region in a predetermined position in a stable manner for a long period of time and to a process for the preparation of the diamond layer of a uniform quality in a large area by the plasma formed in a large region by the microwave plasma generating apparatus, a diamond layer being excellent in quality, specification and the like and capable of being employed conveniently for a variety of fields including optoelectronics field and the like.

## BACKGROUND ART

Microwave plasma generating apparatus is an apparatus for generating plasma by radiating microwaves into a discharging space containing raw material gases for discharging plasma.

Conventional microwave plasma generating apparatuses of this kind, however, have the drawback that no plasma can be made larger due to limited electric power when a single electric source is employed.

As a method for improving the defect of the conventional apparatuses generating microwave plasma, there is proposed technology for introducing microwaves into the discharging space from multiple directions, as disclosed in Japanese Patent Laid-open Publication (kokai) No. 64-24,094.

Such a conventional process for the preparation of the diamond layer, however, presents the extreme difficulty that plasma of a large region cannot be generated stably in a predetermined position for a long period of time because microwaves interfere with each other and as a result the phase differential of microwaves may be caused to vary and the plasma migrates.

This means that a diamond layer having a uniform thickness cannot be formed efficiently on a substrate member of a large area when the diamond layer is to be deposited by utilizing such a microwave plasma generating apparatus.

The object of the present invention is to solve the aforesaid problems, that is, to provide the microwave plasma generating apparatus capable of generating the plasma of a large region in a predetermined position in a stable manner for a long period of time and a process for the preparation of the diamond layer by utilizing the same.

## DISCLOSURE OF INVENTION

As a result of extensive research on means for solving the aforesaid problems, the present inventors have acquired the knowledge as will be described hereinafter. First, attempts have been made to make a region of plasma larger (a volume of plasma larger) by providing the microwave plasma generating apparatus with a plurality of microwave radiation means for radiating microwaves and adjusting positions of introducing microwaves so as to make a comprehensive region of the plasma larger by connecting the adjacent regions of the plasma generated by the radiation of the microwaves from the corresponding microwave radiation means for radiating microwaves in the discharging space (within a reactor) utilizing the plasma so as to overlap partially with each other.

This process enables the region of plasma to be made larger and can generate the plasma of the large region by connecting the respective plasma regions to each other so as to cover a wide area of the substrate plate disposed in the reactor. However, it has been found in this instance that, when the microwaves are radiated concurrently from the plural microwave radiation means, the microwaves cause interference with each other within the reactor and the plasma lighted up is likely to migrate, thereby making it difficult to generate a large region of plasma in a stable manner.

Therefore, the present inventors have found it possible to generate and retain plasma of a large region in a stable manner for a long period of time, while avoiding hazardous interaction such as interference of microwaves with each other, by converting the microwaves into pulses and radiating the microwave pulses one after another continuously or substantially continuously from the corresponding plural microwave radiation sources in such a manner that the radiation of the microwaves staggers the timing of radiation in an appropriate way.

The present inventors have completed the present invention on the basis of this finding.

In other words, the present invention provides the microwave plasma generating apparatus so adapted as to generate plasma by radiating microwaves into a discharging space, which is characterized by a plurality of microwave radiation means for radiating microwave pulses continuously by staggering the timing of radiation of the microwave pulses.

Further, the present invention provides the method for the preparation of a diamond layer characterized by synthesizing the diamond layer by using the microwave plasma generating apparatus as described in claim 1.

## BRIEF DESCRIPTION OF DRAWINGS

Figs. 1 and 6 are plan views describing a preferred mode of the microwave plasma generating apparatus according to the present invention and showing an essential portion thereof (an almost overall representation).

Fig. 2 is a partial side view showing a reactor portion and its vicinity of Fig. 1.

Figs. 3 and 7 are graphs showing examples of timing of radiating the microwave pulses, which can appropriately be adopted to generate and retain plasma of a large region within the reactor in a stable manner for a long period of time by using the microwave plasma generating apparatus of the present invention as illustrated in Fig. 1.

Fig. 4 is a graph showing an outline of (a) changes in a plasma density in one cycle relative to the position coordinate and (b) changes relative to the time, when the microwave pulses are radiated in the radiation mode in Fig. 3.

Fig. 5 is a graph showing a radiation mode (a) of a pulse to be radiated from means I for radiating the microwaves, out of radiation modes of the microwave pulses as shown in Fig. 3, and cycles of periodical changes of density of unit plasma corresponding to the microwave pulses.

In the drawings, reference symbols stand for as follows:

I-IV:
microwave radiation means
MG1-MG4:
microwave oscillating sources
WG1-WG4:
waveguide tubes
IS1-IS4:
isolators
DC1-DC4:
directional couplers
TU1-TU4:
tuners
UP1-UP4:
unit plasma
SH:
substrate plate holder
PL1-PL4 & PL:
plungers
PR:
plasma (plasma integrated in a large region)
R:
reactor (discharging space)
$L_{12}$, $L_{23}$, $L_{34}$:
intervals of positions
TC:
timing controller
PG:
pulse generator
AT:
attenuator
OS:
oscilloscope
PM:

power meter
PF:
plasma separating fin
SB:
substrate plate
MI:
intensity of microwave
PD, UPD1-UPD4 & PPD:
plasma density

BEST MODE FOR CARRYING OUT THE INVENTION

A detailed description will be made on the microwave plasma generating apparatus and on the method for the preparation of the diamond layer by taking advantage of the microwave plasma generating apparatus according to the present invention.

- Microwave Plasma Generating Apparatus -

The microwave plasma generating apparatus according to the present invention is provided with a plurality of microwave radiation means for generating microwaves, each being arranged so as to convert the microwaves into pulses and generate the microwave pulses continuously by staggering the timing of radiation of the microwave pulses.

The microwave radiation means for generating the microwaves usually comprises a microwave oscillating source for oscillating microwaves and a waveguide tube.

As the microwave oscillating source for oscillating the microwaves, there may be employed for instance a magnetron.

As the waveguide tube, there may be employed a square-shaped waveguide tube, a rectangular-shaped waveguide tube, a round-shaped waveguide tube, a ridge-shaped waveguide tube, an oval-shaped waveguide tube and the like.

The point of importance for the microwave plasma generating apparatus according to the present invention resides in the fact that the microwave plasma generating apparatus is provided with a timing control mechanism for controlling the timing of radiation of the microwave pulses converted from the microwaves radiated from the corresponding plural microwave radiation means so as to radiate the microwave pulses at least in a continuous way.

AS the timing control mechanism to be employed for controlling the timing of radiation of the microwave pulses, there may be employed, for instance, a sequence-type timer switching mechanism, computer-controlled timing switching mechanism and the like. Although the timing control mechanism may be of such a type as the timing is fixed, it is usually preferred to use a type capable of changing (adjusting) the timing in an appropriate manner.

As long as the microwave plasma generating apparatus according to the present invention has the plurality of the microwave radiation means for radiating microwaves and means for converting the microwaves into pulses and for radiating the microwave pulses continuously in the manner as described hereinabove, the rest of the microwave plasma generating apparatus may be identical or similar to conventional microwave plasma generating apparatuses of this kind.

As a matter of course, for the points other than those described hereinabove, appropriate modifications may be made and a new part or parts may be added so as to adapt the object of the present invention.

For instance, it is desired to mount a tuner for synchronizing microwaves to each of the waveguide tubes in such a manner as will be described hereinafter.

The following is a detailed description on the microwave plasma generating apparatus according to the present invention and on the method for generating and retaining the microwave pulses of a large region in a stable manner for a long period of time by taking advantage of the microwave plasma generating apparatus, with reference to the accompanying drawings.

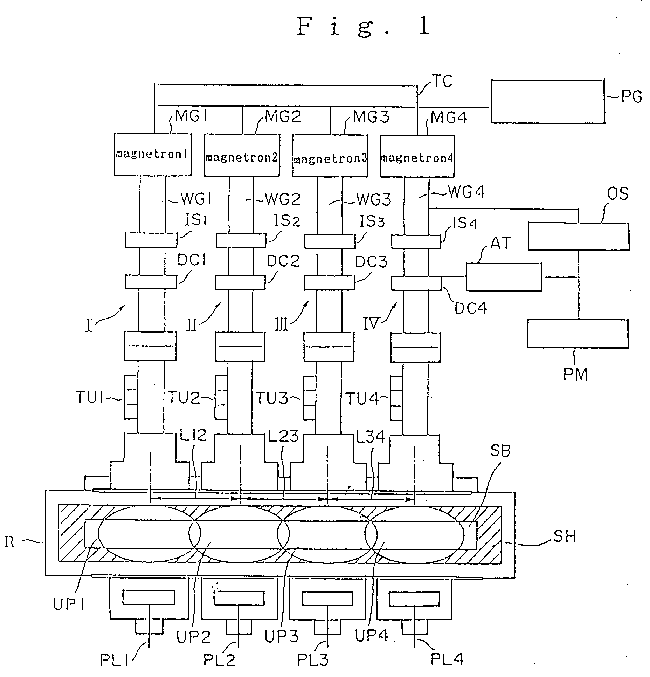

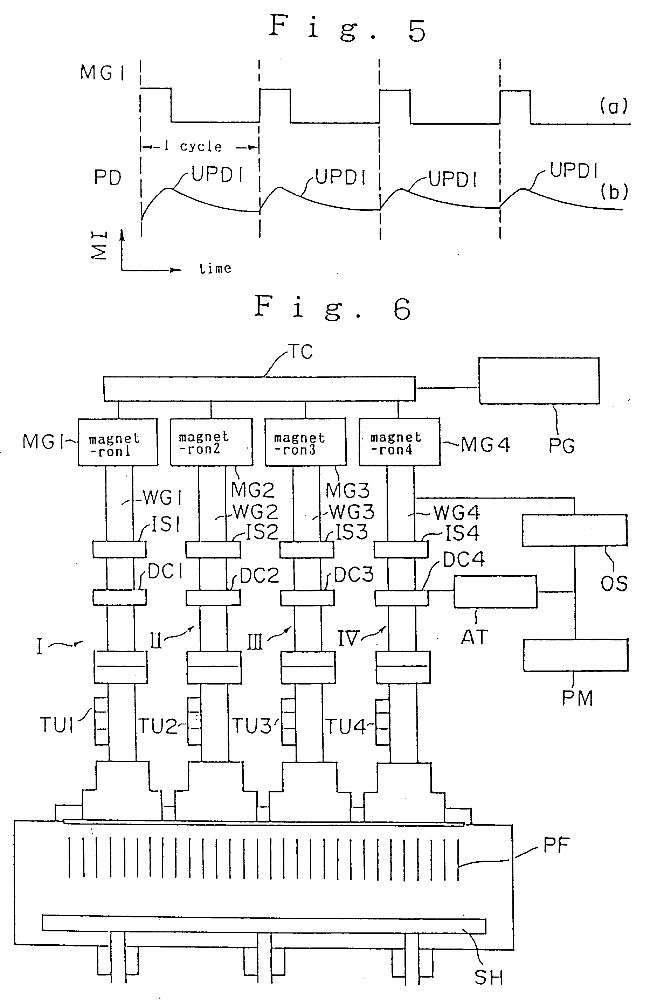

Figs. 1 and 6 are each a plan view describing a preferred mode of the microwave plasma generating apparatus according to the present invention and showing an essential portion thereof.

It is noted herein that the apparatus as illustrated in Fig. 6 is substantially the same basic structure as the apparatus illustrated in Fig. 1, except for the provision of a plasma separating fin PF within the reactor as a mechanism for positioning the plasma, in place of a plunger. Hence, a detailed description is made mainly on the apparatus as illustrated in Fig. 1.

As shown in Fig. 1, the microwave plasma generating apparatus according to the present invention is provided with a plurality of microwave radiation means for radiating microwaves. Although the apparatus as shown in Fig. 1 has four microwave radiation means I to IV, inclusive, it may generally have more than one microwave radiation means as needed.

Each of the microwave radiation means comprises a microwave oscillating source (microwave oscillating source MG1 - MG4 in the example as shown in Fig. 1) for oscillating microwaves (microwave pulses in this case) and a waveguide tube (waveguide tube WG1-WG4 in the example as shown in Fig. 1).

As the microwave oscillating source for oscillating the microwaves, there may preferably be employed a magnetron or the like. In the example as shown in Fig. 1, the magnetron is employed for each of the microwave oscillating sources MG1 to MG4, inclusive, although they are not restricted to the magnetron.

Each of the microwave oscillating sources for oscillating the microwaves (microwave oscillating sources MG1 to MG4 in the example as shown in Fig. 1) is connected with a pulse generator PG as a unit for radiating microwave pulses from each of the microwave oscillating sources. Further, it is further equipped with a timing adjusting mechanism TC for adjusting the timing of radiating the microwave pulses.

In the example as shown in Fig. 1, one pulse generator PG is so arranged as to operate the oscillation of the microwave pulses from all the microwave oscillating sources MG1 to MG4, inclusive, although the number of the pulse generators is not restricted to one. More than one pulse generator may be provided as needed.

In the example as shown in Fig. 1, the timing adjusting mechanism TC is disposed separately from the pulse generator PG and the microwave oscillating source MG1 to MG4. However, the timing adjusting mechanism may be arranged in such a type as being integrated with the pulse generator PG or the microwave oscillating source MG1 - MG4.

As describing above, pulse of microwave can be radiated continuously by each microwave oscillating source in adjusting time because the microwave oscillating source has the pulse generator and the timing adjusting mechanism.

As the waveguide tube in the example as shown in Fig. 1, a rectangular-shaped waveguide tube is employed for each of the waveguide tubes WG1 to WG4, inclusive. It is to be noted, however, that the waveguide tube is not restricted to this shape and that those as illustrated hereinabove may be employed singly or in combination of two or more.

Each of the waveguide tubes is usually provided with an isolator (isolators IS1 TO IS4, inclusive, in the example as shown in Fig. 1) and a directional coupler (directional couplers DC1 to DC4, inclusive, in the example as shown in Fig. 1), as mounted for conventional waveguide tubes of this type.

Further, as in usual cases, it is preferred that each of the waveguide tubes is connected with an oscilloscope and that each of the isolators is connected with an attenuator and further with a power meter. For brevity of the drawings, in the example as shown in Fig. 1, it is shown as if the oscilloscope OS, the attenuator AT and the power meter PM are connected with the microwave radiation means IV only, however, it is noted that in usual cases they are connected to all the desired microwave radiation means (for instance, microwave radiation means I to IV, inclusive, in the example as shown in Fig. 1).

In accordance with the present invention, it is preferred that each of the waveguide tubes is provided with a tuner for synchronizing the microwave pulses (tuner TU1 to TU4 in the example as shown in Fig. 1), for instance, in the manner as shown in Fig. 1.

In the example as shown in Fig. 1, each of the microwave radiation means I to IV and the waveguide tubes WG1 to WG4 are disposed parallel to each other. It is to be noted, however, that generally they are not necessarily arranged parallel to each other. In other words, the microwave pulses may be introduced from each of the microwave radiation means into the reactor R from an arbitrary direction and that the direction may conveniently be chosen as needed.

As will be described hereinafter, the distances between each of the positions ($L_{12}$, $L_{23}$ and $L_{34}$ in the example as shown in Fig. 1) in which the microwave pulses are introduced from the microwave radiation means may conveniently be chosen or adjusted so as to allow the adjacent numbers of unit plasma (UP1 and UP2, UP3 and UP4 or UP3 and UP4, inclusive, in the example as shown in Fig. 1), out of the unit plasma generated by the microwave pulses from the microwave radiation means (unit plasma UP1 to UP4, inclusive, in the example as shown in Fig. 1), to overlap partially with each other in an efficient way, integrating plasma in a large region (plasma RP in the example as shown in Fig. 1). In other words, the magnitude of the unit plasma to be generated by each of the microwave pulses may vary in accordance with other conditions including conditions for generating plasma, such as the kind of raw material gases to be employed for generating plasma, the kind of reaction for utilization of plasma, and the like, so that the intervals of the unit plasma, such as $L_{12}$, $L_{23}$ and $L_{34}$, cannot be generally defined in a uniform manner. It is to be noted, however, that the preferred intervals can be determined on the basis of data obtained in advance by experimentation or the like.

It is noted herein that, although it is shown in the example as shown in Fig. 1 as if the distances $L_{12}$, $L_{23}$ and $L_{34}$ are fixed, the microwave plasma generating apparatus according to the present invention is generally configured that the distance between the positions in which the microwave pulses are to be introduced may conveniently be adjusted as to be variable.

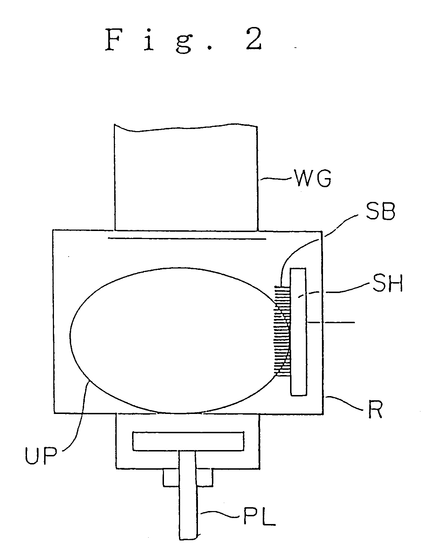

As is apparent from Fig. 2, too, the unit plasma UP1 to UP4 generated from the microwave radiation means I to IV are arranged to be linear in the example as shown in Fig. 1. In accordance with the present invention, however, the arrangement for the unit plasma is not necessarily linear and it may be so arbitrary that the unit plasma may be arranged in such a second-dimensional way as, for instance, the unit plasma overlapping with each other in the longitudinal direction as shown in Fig. 1.

The microwave plasma generating apparatus according to the present invention has a discharging space in which the plasma generated is utilized, or a reactor (the reactor R in the example as shown in Fig. 1).

The shape of the reactor is not limited to a particular one and may conveniently be chosen from any arbitrary shape as needed. As the microwave plasma generating apparatus according to the present invention is so arranged that the plasma generated in a large region can be utilized and as a consequence that the plasma reaction or treatment with plasma can be carried out over the wide area of the substrate plate larger than in conventional cases, it may be equipped with a reactor having a large capacity (having a large bottom area) that complies with the wide area of the substrate plate.

It is further preferred that the microwave plasma generating apparatus according to the present invention is provided with a mechanism for positioning the generated plasma as in usual cases.

As the mechanism for positioning the plasma, there may conveniently be employed one that has been conventionally employed, such as a short plunger or the like. In the example as shown in Figs. 1 and 2, plungers PL1 to PL4 are mounted as the mechanism for positioning the plasma, and the short plunger or the like may usually be conveniently employed for each of the plungers PL1 to PL4, inclusive.

It is also possible to mount, for example, a plasma separating fin PF in a manner as shown in Fig. 6, for the purpose to locate the plasma in a particular position or for other purposes.

The kind of the substrate plate holder SH and the position in which the substrate plate holder is mounted are not restricted to particular ones. The substrate plate holder SH may be mounted on the bottom surface side of the plasma generated, as shown in Fig. 6, or on the side surface portion of the plasma, as shown in Fig. 2. Further, the substrate plate holder is not restricted to the one of a fixed type as shown in the drawings, and it may be of a type of, for example, a belt conveyor. The substrate plate holder of the type of the belt conveyor allows diamond layer to deposit on the substrate plate each other. Further, in the example as shown in Fig. 2, the plunger PL is disposed at the bottom surface portion of the plasma, whereby the substrate plate holder is configured so as to allow the positioning of the substrate plate holder SH (substrate plate SB) to be controlled thoroughly independently from the control of the positioning of theplasma.

The microwave plasma generating apparatus according to the present invention may be provided with means for separating the plasma generated, such as the plasma separating fin or the like, in the vicinity of a desired wall surface of the reactor, as needed. More specifically, for instance, as illustrated in Fig. 6, it is preferred that the plasma separating fin PF may conveniently be mounted on a wall surface of the reactor (an upper side wall surface in the example as shown in Fig. 6) so as to cover at least an inlet of the microwave pulses.

In generating the plasma in the discharging space (within the reactor) by taking advantage of the microwave plasma generating apparatus according to the present invention, the desired raw material gases are introduced into the reactor or allowed to flow in the reactor. The raw material gases are caused to generate plasma having a variety of compositions by irradiating the raw material gases with the microwaves.

The raw material gases for generating the plasma are not restricted to particular ones and a variety of conventional raw materials may be utilized. More specifically, the raw material gases which have conveniently been employed may include, for example, air, nitrogen, oxygen, argon, hydrogen, methane, carbon monoxide, carbon dioxide, alcohols, silane, disilane, diborane, fluorine compounds, chlorine, phosphorus, carbon-containing compounds, sulfur-containing compounds, hydrides or organometallic compounds or a mixture of these raw material gases. These raw material gases may be employed singly as they are or in admixture with the other raw material gases.

It is noted as a matter of course that, as needed, the inside of the reactor is made vacuum and the plasma is generated and utilized, for instance, for treatment of a variety of materials with plasma, or the like.

The discharging space may be formed as a hollow resonator by covering an entire inner surface of the reactor forming the discharging space with a metal, although it is not required to form such a hollow resonator. Further, the discharging space may be arranged in such a form that a discharge tube composed of an insulating material is placed within the reactor.

A detailed description will now be made of the method for generating the plasma of a large region in the discharging space (within the reactor) in a stable manner for a long period of time by taking advantage of the microwave plasma generating apparatus according to the present invention, with reference to the accompanying drawings, by taking as an example the case of radiating the microwave pulses from the apparatus with the four-system microwave radiation means, as illustrated in Fig. 1.

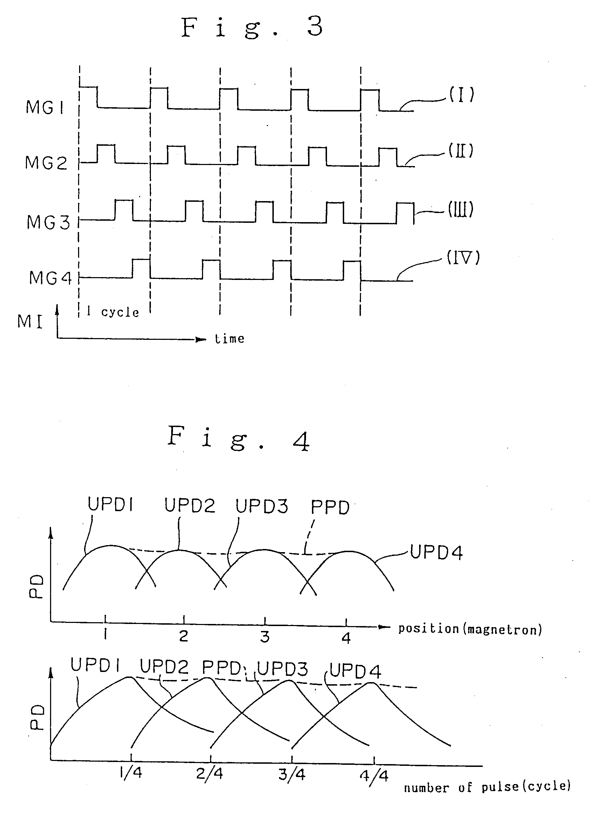

Fig. 3 is a graph showing an example of the timing of radiation of the microwave pulses, which is conveniently adopted for generating the plasma RP of a large region within the reactor R in a stable manner for a long period of time by the microwave plasma generating apparatus as illustrated in Fig. 1. The graphic portions (I) to (IV), inclusive, of Fig. 3 denote periodic changes of the intensity of the microwaves to be radiated and introduced into the reactor R from the microwave oscillating sources MG1 to MG4 of the four-system microwave radiation means I to IV, respectively, as shown in Fig. 1, that is, they denote radiation modes for radiating the microwave pulses. For each of the reference symbols (I) to (IV) of Fig. 3, the x-axis denotes the time or the number of cycles (provided that an interval between vertically extending two broken lines stands for one cycle), while the y-axis denotes the intensity of microwaves (MI).

It is noted herein that the pulses used are shown in the form of a rectangular shape, although the shape of the pulse is not restricted to such a rectangular-shaped pulse. Further, Fig. 3 shows the case in which no pulses overlap with each other, although they may overlap with each other.

In the process as shown in Fig. 3, the microwave pulses having the same pulse width (a one-quarter cycle width each) are radiated and introduced continuously from the microwave oscillating sources MG1 to MG4 in order of sequence of the sources MG1, MG2, MG3 and MG4. The 4-unit microwave pulses form one cycle as one set and the cycles are repeated.

Next, a description will be made on the way of retaining the plasma RP of a large region in a stable manner for a long period of time by the method for the radiation of the microwave pulses, with reference to Figs. 1 and 3.

First, the microwave in the pulse form is radiated and introduced only by a quarter cycle as shown in Fig. 3 from the microwave oscillating source MG1, thereby generating the first unit plasma UP1. It is to be noted herein that plasma including the unit plasma UP1 has generally a certain length of life because it damps its plasma density gradually without disappearing upon suspension of the radiation of the microwave. Following the aforesaid radiation of the microwave pulse, the microwave converted into a pulse having a one-quarter cycle from the following microwave oscillating source MG2 is radiated and introduced in the vicinity of the unit plasma UP1, whereby the unit plasma UP2 is generated as if the remaining unit plasma UP1 functions as seed plasma by damping the previous unit plasma UP1 gradually while increasing the unit plasma UP2 gradually. As a consequence, the unit plasma UP1 is shown as if it is transferred to the unit plasma UP2. Likewise, the sequential radiation of the third and fourth microwave pulses from the respective microwave oscillating sources MG3 and MG4 and the sequential introduction of the plasma are followed, thereby transferring the unit plasma from UP2 through UP3 to UP4.

After the completion of the first cycle comprised of the first to fourth microwave pulses, the fifth to eighth microwave pulses are sequentially radiated and introduced from the respective microwave oscillating sources MG1 to MG4 in the same manner as described above. By repeating the cycles, the plasma PR of a large region consisting of the unit plasma moving at a high speed can be retained in a stable manner for a long period of time.

It is of primary importance that a period of one cycle is set to become satisfactory short. The reason is because, if one cycle is set too long, the portion of the unit plasma UP1 in the plasma RP generated in the previous cycle is caused to damp its plasma density, thereby failing to transfer the unit plasma smoothly and, as a result, to retain the plasma PR integrated in a uniform and stable manner for a long period of time.

The present invention including this matter will be described more in detail.

The states of the variation in the plasma density of one cycle with positions and the periodical changes are considered, for instance, as shown in Fig. 4. Fig. 4(a) shows the variation of the plasma density PD (on the y-axis) relative to the position coordinate (on the x-axis) of the unit plasma UP1 to UP4 in one cycle. In Fig. 4(a), curved lines UPD1 to UPD4, inclusive, stand each for the variation of the plasma density of the unit plasma UP1 to UP4, respectively, in accordance with the positions. It is to be noted herein that, when the central distances $L_{12}$, $L_{23}$ and $L_{34}$ between the centers of the respectively adjacent plasma are set each to a sufficiently short distance in this case, the density of actual plasma (the integrated plasma PR) can be made sufficiently high and uniform over the region of the unit plasma UP1 to UP4 in the manner as indicated by broken line PRD.

On the other hand, Fig. 4(b) shows the periodical changes of the plasma density UPD1 to UPD4 for the respective unit plasma UP1 to UP4 in one cycle. In Fig. 4(b), the x-axis represents the time or number of pulses (period: the interval between the pulses is represented by unit in a period of cycle) and the y-axis represents the plasma density (PD).

When the interval of the pulses (a pulse width in the example as shown in Fig. 3) is shortened to a sufficient extent, the plasma density causes a build-up because the electrons within the plasma are very light, whereby the actual plasma density can be retained over the range of one cycle, as indicated by broken line PRD, in substantially the same state as in the case in which microwaves are introduced in a steady manner.

A description of the procedures for retaining the plasma PR integrated in a large region uniformly and steadily in each cycle in the manner as described above over the cycles in a stable manner for a long period of time will now be made with reference to Fig. 5 which indicates the state of the periodical changes of the plasma density of the unit plasma UP1 to be generated by the radiation and the introduction of the microwave pulses from the microwave oscillating source MG1.

Although, as shown in Fig. 3, the microwave pulses are radiated and introduced in the first quarter cycle unit of each cycle from the microwave oscillating source MG1. Fig. 5(a) indicates only the mode of introducing the pulses. It is considered that the plasma density of the unit plasma UP1 in each cycle changes periodically by the introduction of the plasma in the manner as indicated by curved line PRD in Fig. 5(a). It is to be noted herein that, if the period of one cycle is set to a sufficiently short extent (in other words, if the widths of the four-system pulses would be sufficiently short in this case), the plasma density causes a build-up as in the aforesaid case, thereby allowing the plasma density of the portion of the unit plasma UP1 in the integrated plasma PR to be retained in a stable manner for a long period of time over the entire range of the cycles. In the same manner as above, the plasma density of the portions of the unit plasma UP2 to UP4, inclusive, in the microwave pulses from the respective microwave oscillating sources MG2 to MG4 can also be retained stably for a long period of time over the entire region of the cycles.

As a comprehensive result of the foregoing, it is to be noted that the plasma can be generated in a uniform and stable manner for a long period of time in such a large region within the reactor as being covered by the unit plasma UP1 to UP4 within the reactor R by setting the distances $L_{12}$, $L_{23}$ and $L_{34}$ between the respectively adjacent unit plasma in an appropriate way and, for example, by using the modes of radiating and introducing the microwave pulses as indicated in Fig. 3 and by making the time of one cycle (the pulse width in this example) sufficiently short, in substantially the same manner as in the case where microwaves are introduced in a steady way.

Although the case where the four-system microwave radiation means are provided as shown in Fig. 1 is taken as an example in order to brief the foregoing description, any number more than one microwave radiation means may generally be provided. It is to be noted as a matter of course that more than four microwave radiation means can generate integrated plasma of a large region uniformly and stably for a long period of time in accordance with the same principle as in the case where the four-system microwave radiation means is provided, plasma consisting of the number of unit plasma corresponding to the number of microwave radiation means provided.

Further, it is to be noted that, although more than one pulse is radiated and introduced so as not to overlap with each other in terms of time, in the example of the radiation mode for the radiation of the microwave pulses as shown in Fig. 3, the microwave pulses that do not correspond to the adjacent unit plasma, for example, more than one, may be radiated and introduced concurrently or in such a manner as allowing their portions to overlap with each other in terms of time.

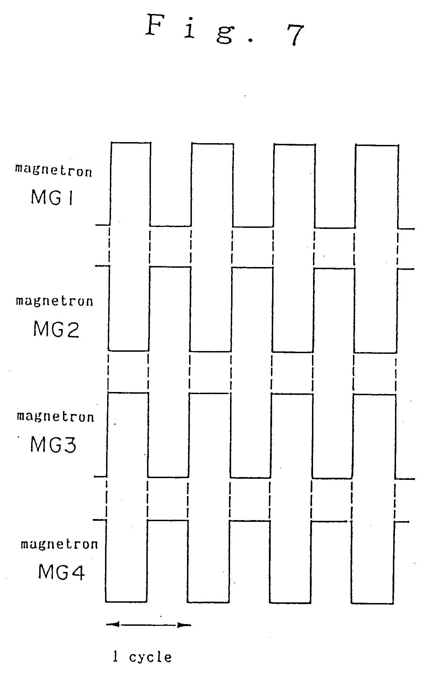

More specifically, for example, when the four-system microwave radiation means are employed as in the example as shown in Fig. 1, the microwave pulses having each the width of a half cycle are radiated and introduced concurrently from the respective microwave oscillating sources MG1 and MG3 by employing a pattern of pulses as illustrated in Fig. 7, thereby lighting up the unit plasma UP1 and UP3 concurrently, which are not adjacent to each other, followed by radiating and introducing the microwave pulses each having the width of a half cycle from the respective microwave radiation means MG2 and MG4 and lighting up the unit plasma UP2 and UP4 in a concurrent way. This procedure comprising repeating the cycles in the aforesaid manner can conveniently be employed.

It is to be noted herein, however, that if more than one microwave pulse, which can generate the adjacent unit plasma, would be radiated and introduced concurrently or in such a manner as overlapping with each other, these microwaves cause interference with each other, thereby failing to retain a desired plasma stably in a large region.

It is further to be noted that any mode of radiating the microwave pulses may be adopted if the interference between the microwaves can be avoided and a build-up of the plasma density of the given unit plasma can be achieved in an efficient fashion. In addition, the shape of the pulse may not necessarily be restricted to a rectangular shape as in the case described above and any shape can be chosen from arbitrary shapes as long as no object of the present invention is impaired. Furthermore, a short interval between the microwave pulses can be provided if the efficient build-up of the pulse density can be achieved.

As the pulse width of the microwave pulse varies in accordance with the number of the microwave radiation means to be employed, the kind of the raw material gases to be employed for generating the plasma and other conditions, it cannot be determined in a uniform manner. In usual cases, however, the pulse width may be in the range of from approximately 0.1 microsecond to 1 second, preferably from approximately 1 microsecond to 100 milliseconds, more preferably from approximately 10 microseconds to 1 millisecond.

The interval between the positions in which the microwave pulses for generating the adjacent unit plasma are introduced ($L_{12}$, $L_{23}$ and $L_{34}$ in the example as shown in Fig. 1) cannot be determined in a uniform manner because the interval between them varies in accordance with the intensity and width of the microwave pulses to be employed, the shape of the waveguide tube, the kind of the raw material gases to be employed for generating the plasma and other conditions. It is to be noted, however, that the interval between them may usually be in the range of from approximately 30 mm to 60 mm, preferably from approximately 40 mm to 50 mm. If the interval is set too long, the adjacent unit plasma does not overlap with each other in a sufficient manner to thereby fail to generate the plasma in a large region. On the other hand, if the interval is too short, the size of the plasma relative to the number of the microwave radiation means used becomes too small, thereby causing the problem that efficiency becomes poor in this respect.

The plasma (unit plasma) generated in the manner as described above can be converted into a standing wave by means of, for example, a short plunger, in conventional manner, and the standing wave can be located in a particular position.

For example, the apparatus as shown in Fig. 1 takes advantage of a short plunger (plungers PL1 to PL4, inclusive) capable of locating the plasma in the particular positions.

It is also possible to locate the plasma in the particular positions by mounting the plasma separating fin to the microwave radiation means. The plasma can be positioned in an effective manner by mounting the plasma separating fin PF, for example, in the manner as shown in Fig. 6.

The microwave plasma generating apparatus of this invention can effectively generate stable and uniform plasma in a desired large area in a reactor.

It is noted herein that the microwave plasma generating apparatus according to the present invention can be utilized effectively in various fields in which plasma can be utilized as well as in conventional fields in which the plasma is utilized. The microwave plasma generating apparatus is useful particularly for the field that requires a large region of plasma, for example, for the fields in which the reaction and treatment with plasma is employed for synthesis of various films by utilizing plasma CVD method, such as synthesis of a diamond film, or for surface treatment.

It is further to be noted that, when the microwave plasma generating apparatus according to the present invention is employed for the synthesis of the diamond film having a large region or for other purposes in the manner as will be described hereinafter, the substrate plate may be utilized by fixing it in a particular position or by transferring it within the reactor in a convenient manner.

- Method for the Preparation of Diamond Layers-

The microwave plasma generating apparatus according to the present invention can be adapted to various uses and, among those, particularly to the preparation of diamond layers.

A detailed description will now be made of the procedures for the preparation of the diamond layers.

The diamond (multi-crystal) layer may be prepared in the following way by taking advantage of the microwave plasma generating apparatus according to the present invention.

In other words, the microwave plasma generating apparatus according to the present invention is adapted to yield the diamond layer by supplying the discharging space (within the reactor) with carbon source gases, irradiating the carbon source gases with microwaves from the microwave radiation means, thereby exciting the carbon source gases and bringing the resulting plasma into contact with the surface of a substrate member.

As the carbon source gases, there may be mentioned, for example, gases of various hydrocarbons, halogenated compounds, oxygen-containing compounds, nitrogen-containing compounds or the like or gases obtainable by gasifying carbon such as graphite or the like.

As the hydrocarbons, there may be mentioned, for example, a paraffinic hydrocarbon such as methane, ethane, propane, butane, etc., an olefinic hydrocarbon such as ethylene, propylene, butylene, etc., an acetylenic hydrocarbon such as acetylene, allylene, etc., a diolefinic hydrocarbon such as butadiene, etc., an alicyclic hydrocarbonsuch as cyclopropane, cyclobutane, cyclopentane, cyclo- hexane, etc., an aromatic hydrocarbon such as cyclobuta-diene, benzene, toluene, xylene, naphthalene, etc., and so on.

As the halogenated compounds, there may be mentioned, for example, a halogenated hydrocarbon such as a halogenated methane, a halogenated ethane, a halogenated benzene, etc., carbon tetrachloride, and so on.

As the oxygen-containing compounds, there may be mentioned, for example, a ketone such as acetone, diethyl ketone, benzophenone, etc., an alcohol such as methanol, ethanol, propanol, butanol, etc., an ether such as methyl ether, ethyl ether, ethyl methyl ether, methyl propyl ether, ethyl propyl ether, phenol ether, acetal, a cyclic ether (dioxane, ethylene oxide, etc.), etc., a ketone such as acetone, pinacolin, methyl oxide, an aromatic ketone (acetophenone, benzophenone, etc.), diketone, a cyclic ketone, etc., an aldehyde such as formaldehyde, acetaldehyde, butylaldehyde, benzaldehyde, etc., an organic acid such as formic acid, acetic acid, propionic acid, succinic acid, butyric acid, oxalic acid, tartaric acid, stearic acid, etc., an acid ester such as methyl acetate, ethyl acetate, etc., a divalent alcohol such as ethylene glycol, diethylene glycol, etc., carbon monoxide, carbon dioxide, and so on.

As the nitrogen-containing compounds, there may be mentioned, for example, an amine such as trimethyl amine, triethyl amine, etc.

In addition, although not a single substance, there may be employed, as the carbon source gases, gases of dangerous things belonging to Class 4 defined by the Fire Services Act in Japan, class 1 petroleums such as gasoline and the like, class 2 petroleums such as kerosene, turpentine oil, camphor oil, pine oil and the like, class 3 petroleums such as heavy oil and the like, and class 4 petroleums such as gear oil, cylinder oil and the like. A mixture with various carbon compounds can also be employed.

Among those carbon source gases, preferred are paraffinic hydrocarbons such as methane which is gaseous at room temperature or high in vapor pressure, ethane, propane, etc., ketones such as acetone, benzophenone, etc., alcohols such as methanol, ethanol, etc., and the oxygen-containing compounds such as carbon monoxide, carbon dioxide, etc. Carbon monoxide is particularly preferred.

In the formation of the diamond film, gases for dilution may also be employed, together with the carbon source gases. Such diluting gases may include, for example, hydrogen gas or inert gases such as helium gas, argon gas, neon gas, xenon gas, nitrogen gas or the like.

These gases may be employed singly or in combination of two or more gases.

The carbon source gases may be admixed with the hydrogen gas. In this case, the hydrogen gas is not restricted to particular ones and it may include one obtainable, for example, by gasification of petroleums, modification of natural gas, water gas or the like, electrolysis of water, reaction of iron with steam, complete gasification of coal, or the like. These gases are purified to a sufficient extent prior to admixture.

The hydrogen constituting the hydrogen gas generates atomic hydrogen when excited.

Although the mechanism is not clarified yet, the atomic hydrogen is considered to demonstrate the catalytic action of activating the reaction for forming the diamond. Further, it has the action of removing non-diamond components such as graphite, amorphous carbon, etc., which may be deposited together with the diamond.

The concentration of the carbon source gases in the total gases may usually range from 0.1% to 80% by volume in the formation of the diamond layer.

The temperature on the surface of the substrate member may range usually from 500 °C to 1,100 °C.

The reaction pressure may range usually from $10^{-6}$ torr to $10^3$ torr, preferably from $10^{-6}$ torr to 800 torr. If the reaction pressure would be lower than $10^{-6}$ torr, on the one hand, the velocity at which the diamond layer is deposited may be too slow or no diamond may be deposited. If the reaction pressure would be higher than $10^3$ torr, on the other hand, no effect is achieved to such an extent as complying with such high reaction pressure.

The reaction time may be set in an appropriate way in accordance with the kind of the substrate members, uses and the like, so as to provide a required thickness of diamond layer.

The diamond layer can be formed on the surface of the substrate member in the manner as described hereinabove. The substrate member with the diamond layer formed thereon may be applied to cutting tools, anti-wear members, tool parts, medical tools such as scalpels, dental drills and the like. In addition, it can be applied to heat sinks, electronic devices and so on.

[Examples]

The present invention will now be described by way of examples with reference to comparative examples. It is to be noted herein that the present invention is not restricted at all to the examples in any respect.

(Example 1)

There was employed a microwave plasma generating apparatus having four-system microwave radiation means I to IV, inclusive, as shown in Fig. 1 (which employs magnetrons (MG1 to MG4) for microwave oscillating sources MG1 to MG4, respectively). The microwave oscillating sources MG1 to MG4 are arranged so as to radiate microwave pulses one after another by operating a pulse generator PG and a timing controller TC so as to assume the radiation mode of radiation of the microwave pulses as indicated by Fig. 3 and introduce the microwave pulses into the reactor R where plasma was generated. In this case, the following conditions were adopted and the resulting plasma (unit plasma UP1 to UP4) was located in the particular positions by means of short plungers (plungers PL1 to PL4), respectively.

Gases within the reactor R: Ar

Pressure of gases within the reactor R: 40 Torr

Pulse width of each microwave pulse: 2 msec

Interval between adjacent waveguide tubes: 5 cm

Output of microwave: 600 W (output of each magnetron)

It was found as a result that uniform plasma having a region as large as approximately 5 cm by 5 cm by 20 cm (plasma RP integrated in a large region) was generated and retained in a stationary and stable manner over the period of time as long as 5 hours during which the microwave pulses were introduced.

(Comparative Example 1)

Plasma was generated by means of the microwave plasma generating apparatus as indicated in Fig. 1 in substantially the same conditions as in Example 1, except for the fact that the plasma was generated by introducing the microwaves concurrently and continuously from the four-system microwave radiation means I to IV (microwave oscillating sources (magnetrons) MG1 to MG4) without conversion into pulses.

It was found as a result that the generation of plasma was recognized immediately after the start of introduction of the microwaves in a region as large as approximately 5 cm by 5 cm by 20 cm. However, it was noted that the plasma has been broken into pieces which in turn were located as they were, without generating and retaining stable plasma in a large region.

(Example 2)

There was employed a microwave plasma generating apparatus having four-system microwave radiation means I to IV, inclusive, as shown in Fig. 1 (which employs magnetrons (MG1 to MG4) for microwave oscillating sources MG1 to MG4, respectively, and a substrate plate holder SH is mounted within the reactor R in the manner as shown in Fig. 1). The microwave oscillating sources (magnetrons) MG1 to MG4 are arranged so as to radiate microwave pulses one after another by operating a pulse generator PG and a timing controller TC so as to assume the radiation mode of radiation of the microwave pulses as indicated by Fig. 3 and introduce the microwave pulses into the reactor R where plasma was generated. In this case, a diamond film was synthesized in the following conditions on the substrate plate SB mounted on the substrate plate holder SH while locating the resulting plasma (unit plasma UP1 to UP4) in the particular positions by means of short plungers (plungers PL1 to PL4), respectively, while generating the plasma RP in a large region.

Raw material gases introduced (flowing) within the reactor:

Composition $CO/H_2$ = 15/85 (volume ratio);

Flow rate: 10 sccm

Pressure of gases within the reactor: 40 Torr (total pressure)

Output of microwave: 600 W (output of each magnetron)

Pulse width of each microwave pulse: 0.1 msec

Interval between adjacent microwave pulses: 5 cm

Substrate plate: Si wafer, 5 cm x 20 cm (scratched treatment with diamond powder for grinding)

Reaction time: 5 hours

It was found as a result that a diamond film having a substantially uniform film thickness was formed at the growth rate of approximately 2 micrometer per hour.

(Comparative Example 2)

A diamond film was synthesized on the substrate plate in substantially the same manner as in Example 2, except for generating plasma concurrently and continuously from the four-system microwave radiation means I to IV [microwave oscillating sources (magnetrons) MG1 to MG4] by means of the microwave plasma generating apparatus as employed in Example 2 without converting the microwaves into pulses.

As a result, the plasma itself was caused to be broken within short and the broken plasma was allowed to localize as it was. Hence, only a portion of the diamond film was formed on the substrate plate in a spotted way.

(Example 3)

There was employed a microwave plasma generating apparatus having four-system microwave radiation means I to IV, inclusive, as shown in Fig. 1 (which employs magnetrons (MG1 to MG4) for the microwave oscillating sources MG1 to MG4, respectively). The microwave oscillating sources (magnetrons) MG1 to MG4 are arranged so as for two (each of MG1 and MG3 as well as MG2 and MG4) out of the microwave oscillating sources (magnetrons) MG1 to MG4 to radiate microwave pulses one after another by operating a pulse generator PG and a timing controller TC so as to assume the radiation mode of radiation of the microwave pulses as indicated by Fig. 7 and introduce the microwave pulses into the reactor R, whereby the diamond layer was synthesized on the substrate plate SB mounted on the substrate plate holder SH while by locating the resulting plasma in their particular positions by the short plungers (plungers PL1 to PL4) and generating the plasma RP in a large region.

The conditions for the synthesis of the diamond layer were the same as those adopted in Example 2.

It was found as a consequence that the diamond layer was formed in almost uniform thickness over the entire area of the substrate plate in substantially the same manner as in Example 2. Further, in this case, the rate of growth of the diamond layer was found to be approximately 3 micrometers per hour.

(Example 4)

Plasma was generated under the same mode of radiation of the microwave pulses (by using a pattern of the pulses as shown in Fig. 3) and in the same conditions of radiating plasma in substantially the same manner as in Example 1, except for locating the plasma in its particular positions by the plasma separating fin PF in the microwave plasma generating apparatus with the plasma separating fin PF mounted in the reactor R as shown in Fig. 6.

The results revealed that uniform plasma (plasma RP integrated in a large region) having the region as large as approximately 5 cm by 5 cm by 20 cm was generated and retained in a stationary and stable manner over the long period of time (5 hours) during which the microwave pulses were introduced.

Even if the radiation mode of radiation of the microwave pulses was replaced by that as employed in Example 3 (by using the pattern of the pulses as shown in Fig. 7), the plasma of a large region was generated and retained in a stable manner for a long period of time, as have been described hereinabove.

INDUSTRIAL APPLICABILITY

The microwave plasma generating apparatus according to the present invention is provided with a plurality of microwave radiation means and it is constructed so as to convert the microwaves into pulses and to radiate and introduce the resulting pulses continuously in various modes of radiation. Hence, the microwave plasma generating apparatus according to the present invention has superior functions because uniform plasma can be generated in given positions in a large region in a stable manner for a long period of time, so that it can be applied to the preparation of diamond layers by applying the plasma to raw materials, and the like. Further, the method for the preparation of the diamond layer according to the present invention can generate and retain uniform plasma in a large region over a long period of time by using the microwave plasma generating apparatus, so that the method according to the present invention can be utilized as a method for the preparation of a diamond layer capable of forming uniform diamond layer over a wide area on the substrate plate.

## Claims

1. A microwave plasma generating apparatus for generating plasma by radiating microwaves into a discharging space, characterized by a plurality of microwave radiation means for radiating microwave pulses continuously at a different timing of radiation of the microwave pulses.

2. A microwave plasma generating apparatus for generating plasma in a discharging space by radiating microwaves into raw material gases for the plasma present in the discharging space within a reactor, comprising of:
   a plurality of microwave radiation means each for radiating microwave pulses into a region for generating the plasma, said region being disposed so as to be adjacent another region in the discharging space within the reactor; and
   a timing control mechanism for controlling the timing of radiation of the microwave pulses by each of the microwave radiation means so as to stagger the timing of radiation of the microwave pulses by the adjacent microwave radiation means out of said plural microwave radiation means.

3. A microwave plasma generating apparatus as claimed in claim 2, wherein said microwave radiation means comprises a microwave oscillating source for oscillating microwaves and a waveguide tube for guiding microwaves oscillated from the microwave oscillating means into the discharging space.

4. A microwave plasma generating apparatus as claimed in claim 2, wherein said timing control mechanism comprises a timing controller.

5. A method for the preparation of a diamond layer characterized by synthesizing a diamond film by using said microwave plasma generating apparatus as described in claim 1.

6. A method for the preparation of a diamond layer on a surface of a substrate member by irradiating carbon source gases introduced into a discharging space within a reactor with microwaves and contacting plasma generated upon radiation of the microwaves with a substrate member, comprising of irradiating carbon source gases within the discharging space with microwave pulses radiated from a plurality of microwave radiation means so as to make a region for generating plasma in the discharging space within the reactor adjacent another region and to stagger the timing of radiation of the microwave pulses to be radiated from the adjacent microwave radiation means out of the plurality of the microwave radiation means.

Fig. 1

# F i g .  2

WG

SB

SH

R

UP

PL

# Fig. 3

MG1 ———————————— (I)

MG2 ———————————— (II)

MG3 ———————————— (III)

MG4 ———————————— (IV)

MI

|← 1 cycle →|

→ time

# Fig. 4

UPD1   UPD2   UPD3   PPD

UPD4

PD

position (magnetron)

1    2    3    4

UPD1  UPD2  PPD  UPD3  UPD4

PD

1/4    2/4    3/4    4/4

number of pulse (cycle)

# Fig. 5

# Fig. 6

# F i g .  7

magnetron
MG I

magnetron
MG2

magnetron
MG3

magnetron
MG4

1 cycle

# INTERNATIONAL SEARCH REPORT

International Application No PCT/JP91/01318

**I. CLASSIFICATION OF SUBJECT MATTER** (if several classification symbols apply, indicate all) [6]

According to International Patent Classification (IPC) or to both National Classification and IPC

Int. Cl[5]   B01J19/08, C23C16/50, C30B29/04, B01J19/12,
            C01B31/06, H01L21/205, 21/302, 21/31, H05H1/30, 1/46

**II. FIELDS SEARCHED**

| Minimum Documentation Searched [7] | |
|---|---|
| Classification System | Classification Symbols |
| IPC | B01J19/08, 19/12, C23C16/50, C30B29/04, C01B31/06, H01L21/205, 21/302, 21/31, H05H1/30, 1/46 |

Documentation Searched other than Minimum Documentation
to the Extent that such Documents are Included in the Fields Searched [8]

Jitsuyo Shinan Koho           1926 - 1991
Kokai Jitsuyo Shinan Koho     1971 - 1991

**III. DOCUMENTS CONSIDERED TO BE RELEVANT** [9]

| Category [*] | Citation of Document, [11] with indication, where appropriate, of the relevant passages [12] | Relevant to Claim No. [13] |
|---|---|---|
| X | JP, A, 2-107779 (Carl-Zeiss Stiftung), April 14, 1990 (14. 04. 90) | 1 |
| Y | JP, A, 2-107779 (Carl-Zeiss Stiftung), April 19, 1990 (19. 04. 90) | 2-6 |
| A | JP, A, 60-54996 (Kagaku Gijutsucho Mukizaishitsu Kenkyusho), March 29, 1985 (29. 03. 85), & JP, B2, 62-120 | 1-6 |
| A | JP, A, 62-298106 (NEC Corp.), December 25, 1987 (25. 12. 87), (Family: none) | 1-6 |
| A | JP, A, 1-149965 (Hitachi, Ltd.), June 13, 1989 (13. 06. 89) | 1-6 |
| A | JP, A, 2-129375 (Fujitsu Ltd.), May 17, 1990 (17. 05. 90) | 1-6 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| December 12, 1991 (12. 12. 91) | January 14, 1992 (14. 01. 92) |
| International Searching Authority | Signature of Authorized Officer |
| Japanese Patent Office | |

Form PCT/ISA/210 (second sheet) (January 1985)